(19) Europäisches Patentamt
European Patent Office
Office européen des brevets

(11) **EP 3 799 670 B1**

(12) **EUROPÄISCHE PATENTSCHRIFT**

(45) Veröffentlichungstag und Bekanntmachung des Hinweises auf die Patenterteilung:
**11.01.2023   Patentblatt 2023/02**

(21) Anmeldenummer: **18785862.6**

(22) Anmeldetag: **27.09.2018**

(51) Internationale Patentklassifikation (IPC):
**H02H 1/00** (2006.01)

(52) Gemeinsame Patentklassifikation (CPC):
**H02H 1/0015**

(86) Internationale Anmeldenummer:
**PCT/EP2018/076271**

(87) Internationale Veröffentlichungsnummer:
**WO 2020/064110 (02.04.2020 Gazette 2020/14)**

(54) **NIEDERSPANNUNGSLEISTUNGSSCHALTER UND STÖRLICHTBOGENERKENNUNGSEINHEIT MIT KOMPENSIERUNG WEGEN PHASENVERSCHIEBUNG**

LOW-VOLTAGE POWER SWITCH AND ARC FAULT DETECTION UNIT WITH COMPENSATION DUE TO PHASE SHIFTING

DISJONCTEUR DE PUISSANCE À BASSE TENSION ET UNITÉ DE DÉTECTION D'ARC PARASITE À COMPENSATION EN RAISON DU DÉPHASAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**07.04.2021   Patentblatt 2021/14**

(60) Teilanmeldung:
**22207228.2**
**22207230.8**

(73) Patentinhaber: **Siemens Aktiengesellschaft**
**80333 München (DE)**

(72) Erfinder:
• **WENZLAFF, Karsten**
  **01097 Dresden (DE)**
• **MEYER, Jörg**
  **01157 Dresden (DE)**
• **SCHEGNER, Peter**
  **01259 Dresden (DE)**

(56) Entgegenhaltungen:
**DE-A1-102004 011 023     FR-A1- 3 059 783**

**Beschreibung**

Die Erfindung betrifft eine Störlichtbogenerkennungseinheit für einen Niederspannungswechselstromkreis nach dem Oberbegriff von Patentanspruch 1 und ein Verfahren zur Störlichtbogenerkennung für einen Niederspannungswechselstromkreis nach dem Oberbegriff von Patentanspruch 7.

Leistungsschalter sind Schutzgeräte, die ähnlich wie eine Sicherung funktionieren. Leistungsschalter überwachen den durch sie mittels eines Leiters hindurchfließenden Strom und-unterbrechen den elektrischen Strom bzw. Energiefluss zu einer Energiesenke bzw. einem Verbraucher, was als Auslösung bezeichnet wird, wenn Schutzparameter, wie Stromgrenzwerte oder Strom-Zeitspannengrenzwerte, d.h. wenn ein Stromwert für eine gewisse Zeitspanne vorliegt, überschritten werden. Die eingestellten Stromgrenzwerte oder Strom-Zeitspannengrenzwerte sind entsprechende Auslösegründe. Die Unterbrechung erfolgt beispielsweise durch Kontakte des Leistungsschalters, die geöffnet werden.

Insbesondere für Niederspannungsstromkreise, -anlagen bzw.netze gibt es abhängig von der Höhe des vorgesehenen elektrischen Stromes im elektrischen Stromkreis verschiedene Typen von Leistungsschaltern. Mit Leistungsschalter im Sinne der Erfindung sind insbesondere Schalter gemeint, wie sie in Niederspannungsanlagen für Ströme, insbesondere Nennströme bzw. maximal Ströme, von 63 bis 6300 Ampere eingesetzt werden. Spezieller werden geschlossene Leistungsschalter für Ströme von 63 bis 1600 Ampere, insbesondere von 125 bis 630 oder 1200 Ampere eingesetzt. Offene Leistungsschalter werden insbesondere für Ströme von 630 bis 6300 Ampere, spezieller von 1200 bis 6300 Ampere verwendet.

Offene Leistungsschalter werden auch als Air Circuit Breaker, kurz ACB, und geschlossene Leistungsschalter als Moulded Case Circuit Breaker oder Kompaktleistungsschalter, kurz MCCB, bezeichnet.

Mit Niederspannung sind Spannungen bis 1000 Volt Wechselspannung oder 1500 Volt Gleichspannung gemeint. Mit Niederspannung sind spezieller insbesondere Spannungen gemeint, die größer als die Kleinspannung mit Werten von 50 Volt Wechselspannung oder 120 Volt Gleichspannung sind.

Mit Leistungsschalter im Sinne der Erfindung sind insbesondere Leistungsschalter mit einer als Steuerungseinheit dienenden elektronischen Auslöseeinheit, auch als Electronic Trip Unit, kurz ETU, bezeichnet, gemeint.

In Niederspannungswechselstromkreisen bzw. Niederspannungsanlagen respektive Niederspannungsnetzen sind Kurzschlüsse meist mit auftretenden Störlichtbögen, wie parallele oder serielle Störlichtbögen, verbunden. Besonders in leistungsstarken Verteil- und Schaltanlagen können diese Störlichtbögen bei einer nicht ausreichend schnellen Abschaltung zu verheerenden Zerstörungen von Betriebsmitteln, Anlagenteilen oder kompletten Schaltanlagen führen. Um einen länger andauernden und großflächigen Ausfall der Energieversorgung zu vermeiden und Personen- sowie generell Schäden zu reduzieren, ist es erforderlich derartige Störlichtbögen, insbesondere stromstarke bzw. parallele Störlichtbögen, in wenigen Millisekunden zu erkennen und zu löschen. Konventionelle Schutzsysteme von Energieversorgungsanlagen können unter den geforderten zeitlichen Anforderungen keinen zuverlässigen Schutz bieten.

Schaltlichtbögen, wie sie beim elektrischen Schalten, insbesondere an den Kontakten, auftreten, sind hiermit nicht gemeint.

Mit Störlichtbögen sind Lichtbögen gemeint, wie sie bei elektrischen Fehlern im Stromkreis bzw. in der Anlage auftreten. Beispielsweise können diese durch Kurzschlüsse bzw. schlechte Verbindungen hervorgerufen werden.

Fließt ein Strom in einem fehlerbehafteten Phasenleiter, beispielsweise mit reduziertem Querschnitt, z.B. durch Quetschung, so führt dies bedingt durch die verminderte Stromtragfähigkeit zu einer unzulässigen Erwärmung und in Folge dessen ggf. zum Aufschmelzen des Leiters und einem seriellen Störlichtbogen.

Wenn ein (Fast-)Kurzschluss mit einem anderen Phasenleiter auftritt, wird von einem parallelen Störlichtbogen gesprochen.

Parallele Störlichtbögen können z.B. durch Alterung des Isolationsmaterials oder Präsenz von leitender Verschmutzung zwischen Phasenleitern verursacht werden. Sie können zwischen zwei verschiedenen Phasenleitern, zwischen Phasenleiter (L) und Erdungsleiter (PE), oder zwischen Phasenleiter und Neutralleiter (N) auftreten. In vielen Fällen entsteht der parallele Lichtbogen auch infolge eines seriellen Lichtbogens, z.B. durch unsachgemäße Arbeiten oder falsch dimensionierte Berührungsmittel.

Falls ein Lichtbogen die Eigenschaften eines parallelen und eines seriellen Störlichtbogens aufweist, bezeichnet man dies als kombinierten Störlichtbogen.

Generell stellen Störlichtbögen eine leitende, fehlerhafte Verbindung zwischen Leitern bzw. Anlageteilen her.

Mittlerweile gibt es verschiedene Möglichkeiten Störlichtbögen zu erkennen. Eine Möglichkeit besteht darin, aus gemessenen Spannungs- und Stromwerten durch Auswertung charakteristischer Eigenschaften einen Störlichtbogen zu erkennen. Dies erfolgt häufig dadurch, dass mittels eines Mikroprozessors die Spannungs- und Stromwerte ausgewertet bzw. entsprechende Berechnungen durchgeführt werden. Für viele Algorithmen müssen phasengenaue Spannungs- und Stromwerte vorliegen, um einen Störlichtbogen sicher zu erkennen bzw. Fehler bei der Erkennung zu vermeiden, damit es im Weiteren nicht zu Unterbrechungen des Niederspannungsstromkreises kommt, obwohl kein Störlichtbogen vorlag.

Die Spannungen werden üblicherweise mit Spannungssensoren ermittelt, diese arbeiten üblicherweise phasengenau.

Für die Ermittlung der Ströme wurden bisher Messwiderstände, so genannte Shunts, eingesetzt. Dabei wird die Spannung über einen bekannten Widerstand gemessen und daraus der Strom ermittelt. Damit ist eine phasengenaue Ermittlung der Höhe des Stromes gegeben. Messwiderstände weisen allerdings den Nachteil auf, dass über diese proportional zur Höhe des Stromes erhebliche Verlustleistungen auftreten. Insbesondere in stromstarken Niederspannungswechselstromnetzen sind diese nicht zu vernachlässigen.

Andererseits gibt es Rogowskispulen zur Ermittlung der Höhe des Stromes. Diese liefern eine zum differenzierten Strom proportionale Spannung. Durch Integration dieser Spannung kann die Höhe des Stromes ermittelt werden. Rogowskispulen weisen den Nachteil auf, dass die ermittelte Höhe des Stromes nicht phasengenau ist. Dies wird durch die Streufeldinduktivität der Spule der Rogowskispule erzeugt. Allerdings weisen Rogowskispulen den Vorteil auf, dass sie eine Potentialtrennung, hohe Stromfestigkeit und geringe Baugrößen aufweisen.

Die französische Patentanmeldung FR 3 059 783 A1 offenbart ein Verfahren zum Herstellen eines Messfühlers für einen Leistungsschalter. Gegenstand ist ein Verfahren zur Herstellung eines Messsensors (10), ein mit diesem Verfahren hergestellter Messsensor, ein Leistungsschalter mit einem solchen Messsensor (10) sowie ein Verfahren zur Steuerung eines solchen Leistungsschalters (100). Der Messsensor (10) umfasst mindestens eine Strommesseinheit (12) mit einem Torus, der von einem Primärleiter (R, S, T, N) gekreuzt werden kann, und einem um den Toroid gewickelten ersten Leiter, einem Stromwandler ( 14) gekreuzt von dem Primärleiter (R, S, T, N) und einer Datenverwaltungseinheit (18). Der Messsensor (10) umfasst eine mit dem Primärleiter (R, S, T, N) verbundene Spannungsmesseinheit (16) zum Messen eines in dem Primärleiter (R, S, T, N) auftretenden Potentials.

Die deutsche Patentanmeldung DE 10 2004 011023 A1 offenbart einen drei- oder vierpoliger NiederspannungsLeistungsschalter mit als Stromsensoren dienenden Rogowskispulen. Drei- oder vierpolige Niederspannungs-Leistungsschalter werden teilweise mit einer Einrichtung zur Erdschlusserfassung ausgerüstet. Hierzu muss die vektorielle Summe der Ströme in den drei beziehungsweise vier Leitern des überwachten Netzes gebildet werden. Für die gattungsgemäße Art von Leistungsschaltern werden die Ausgangssignale aller Rogowskispulen (1) über Widerstände (4, 5) gemeinsam auf einen Integrationskondensator (6) geführt, dessen Spannung das Eingangssignal eines weiteren, die Stromsumme im überwachten Netz abbildenden Messverstärkers (7) bildet. Das Ausgangssignal dieses Messverstärkers (7) wird dann in bekannter Weise im Mikroprozessor des Überstromauslösers weiterverarbeitet

Aufgabe der vorliegenden Erfindung ist es, die Verwendung von Rogowskispulen zur Ermittlung phasengenauer Stromwerte, insbesondere zur Störlichtbogenerkennung, speziell für einen Niederspannungsleistungsschalter und eine Störlichtbogenerkennungseinheit, zu ermöglichen.

Diese Aufgabe wird durch eine Störlichtbogenerkennungseinheit mit den Merkmalen des Patentanspruchs 1 oder ein Verfahren mit den Merkmalen des Patentanspruchs 7 gelöst.

Erfindungsgemäß wird eine Anordnung für einen Niederspannungswechselstromkreis, insbesondere ein Niederspannungsleistungsschalter oder eine Störlichtbogenerkennungseinheit, vorgeschlagen, aufweisend:

- mindestens eine Rogowskispule zur Ermittlung der Höhe des elektrischen Stromes eines Leiters, insbesondere Rogowskispulen für alle Leiter, des Niederspannungswechselstromkreises, die eine analoge Spannung (P1) abgibt, die ein Äquivalent der Höhe des elektrischen Stromes des Leiters ist.

Für einen Niederspannungsleistungsschalter ist vorgesehen:

- eine Unterbrechungseinheit mit Kontakten, zur Unterbrechung des Niederspannungswechselstromkreises,
- eine mit der mindestens einen Rogowskispule und der Unterbrechungseinheit verbundene elektronischen Auslöseeinheit mit einem Mikroprozessor, die derart ausgestaltet sind, dass bei Überschreitung von Strom- oder/und Strom-Zeitspannen-Grenzwerten des Phasenleiters eine Unterbrechung des Niederspannungswechselstromkreises veranlasst wird.

Für eine Störlichtbogenerkennungseinheit ist vorgesehen:

- mindestens ein Spannungssensor () zur Ermittlung der Höhe der Spannung des Leiters (I1), insbesondere Spannungssensoren für jeden Leiter, des Niederspannungswechselstromkreises,
- mit einem Mikroprozessor, der mit der ermittelten Höhe des Stromes und der Spannung des Niederspannungswechselstromkreises eine Störlichtbogenerkennung durchführt und bei Überschreitung mindestens eines Grenzwertes ein Störlichtbogenerkennungssignal abgibt.

Die Anordnung ist erfindungsgemäß dadurch ausgestaltet, dass die Rogowskispule (bzw. jede Rogowskispule) mit (je) einem analogen Integrator verbunden ist, dem (je) ein Analog-Digital-Umsetzer folgt, der (jeweils) die integrierte analoge Spannung in (je) ein digitales Signal umsetzt, das (die) durch den Mikroprozessor derart weiterverarbeitet wird (werden), dass die durch die Rogowskispule und von der Rogowskispule nachgeschalteten Komponenten, insbesondere des analogen Integrators, erzeugte Phasenverschiebung kompensiert wird, so dass phasenrichtige Stromwerte ermittelt werden, die für die Erkennung von Fehlersituationen zum Schutz des Niederspannungswechselstromkreises verwendet werden, insbesondere für die Störlichtbogenerkennung.

Dies hat den besonderen Vorteil, dass Rogowskispulen mit den genannten Vorteilen insbesondere für die Erkennung von Störlichtbögen eingesetzt werden können, wobei durch die Kompensation der Phasenverschiebung auch einfache Algorithmen zur Störlichtbogenerkennung verwendet werden können bzw. die Algorithmen hierbei zuverlässige Ergebnisse liefern und fehlerhafte Unterbrechungen des zu schützenden Niederspannungsstromkreises vermieden werden.

Vorteilhafte Ausgestaltungen der Erfindung sind in den Unteransprüchen angegeben.

In einer vorteilhaften Ausgestaltung der Erfindung ist zwischen Rogowskispule und Analog-Digital-Umsetzer ein Verstärker vorgesehen. Speziell kann hier ein Differenzverstärker vorgesehen sein, um eine Anhebung der Amplitude durchzuführen.

Dies hat den besonderen Vorteil, dass neben der phasengenauen Ermittlung von Stromwerten auch eine amplitudenmäßige bzw. - genaue Anpassung erfolgen kann.

In einer vorteilhaften Ausgestaltung der Erfindung ist der Rogowskispule oder dem Integrator ein Filter nachgeschaltet oder dem Analog-Digital-Umsetzer ein Filter vorgeschaltet. Dies hat den besonderen Vorteil, dass eine Filterung des analogen Signals erfolgen kann, um Störkomponenten auszublenden oder eine bessere Frequenzbegrenzung des analog zu digital umzusetzenden Signals zu erreichen.

In einer vorteilhaften Ausgestaltung der Erfindung ist die Rogowskispule durch eine Gegeninduktivität, eine Streufeldinduktivität und einen Wicklungswiderstand gekennzeichnet;

der analoge Integrator weist mindestens eine Widerstands-Kondensator Anordnung auf, mit einer resultierenden Kapazität und einem resultierenden Widerstand.

Dies hat den besonderen Vorteil, dass neben der Auswahl der wesentlichen Größen der Rogowskispule eine besonders einfache Realisierung eines analogen Integrators zur Verfügung steht.

In einer vorteilhaften Ausgestaltung der Erfindung werden aus dem digitalen Signal mittels der Gegeninduktivität, der Streufeldinduktivität, der resultierenden Kapazität und der Summe aus Wicklungswiderstand und resultierenden Widerstand phasenrichtige Stromwerte errechnet.

Dies hat den besonderen Vorteil, dass mit wenigen signifikanten Werten, beispielsweise mindestens 2 Werten, eine Ermittlung phasengenauer Stromwerte ermöglicht wird.

In einer vorteilhaften Ausgestaltung der Erfindung werden die phasenrichtigen digitalen Stromwerte der Höhe des Stromes des Leiters durch folgende Formel errechnet:

$$i_\mathrm{P}(t) = \int \frac{LC \frac{\mathrm{d}^2 u_\mathrm{C}(t)}{\mathrm{d}^2 t} + RC \frac{\mathrm{d} u_\mathrm{C}(t)}{\mathrm{d}t} + u_\mathrm{C}(t)}{M} \, \mathrm{d}t + C \frac{\mathrm{d} u_\mathrm{C}(t)}{\mathrm{d}t}$$

Dies hat den besonderen Vorteil, dass eine spezifische Berechnungsmöglichkeit für die phasengenauen bzw. phasenrichtigen Stromwerte gegeben ist.

Erfindungsgemäß wird ferner ein analoges Verfahren beansprucht,

- bei dem Spanungswerte mindestens eines Leiter des Niederspannungswechselstromkreis ermittelt werden,
- bei dem mit einer Rogowskispule Stromwerte des mindestens einem Leiters des Niederspannungswechselstromkreis ermittelt werden, wobei die Rogowskispule eine analoge Spannung abgibt, die ein Äquivalent der Höhe des elektrischen Stromes des Leiters ist,
- die Spannungswerte und Stromwerte einem Mikroprozessor zugeführt werden, der derart ausgestaltet ist, das eine Störlichtbogenerkennung durchgeführt wird und bei Überschreitung mindestens eines Grenzwertes ein Störlichtbogenerkennungssignal abgegeben wird.

Erfindungsgemäß wird die analoge Spannung integriert und derart weiterverarbeitet, dass die durch die Rogowskispule und den Integrator, und gegebenenfalls weitere Komponenten, erzeugte Phasenverschiebung kompensiert wird, derart dass phasenrichtige Stromwerte für die Störlichtbogenerkennung ermittelt und verwendet werden.

Alle Ausgestaltungen, sowohl in abhängiger Form rückbezogen auf den Patentanspruch 1, 3 oder 9, als auch rückbezogen lediglich auf einzelne Merkmale oder Merkmalskombinationen von Patentansprüchen, bewirken eine Verbesserung des Einsatzes einer Rogowskispule, insbesondere für die Ermittlung von Störlichtbögen.

Die beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit der Zeichnung näher erläutert werden.

In der zugehörigen Zeichnung zeigt:

Figur 1 ein Blockschaltbild eines Niederspannungsleistungsschalters;

Figur 2 ein Blockschaltbild einer Störlichtbogenerkennungseinheit;

Figur 3 eine erfindungsgemäße Anordnung;

Figur 4 ein Ersatzschaltbild einer Rogowskispule;

Figur 5 ein erstes Diagramm mit einem Spannungs- und Stromverlauf;

Figur 6 ein Ersatzschaltbild einer Rogowskispule und eines Integrators;

Figur 7 ein zweites Diagramm mit einem Spannungs- und Stromverlauf;

Figur 8 ein Ersatzschaltbild mit zusammengefassten Komponenten;

Figur 9 ein drittes Diagramm mit einem ersten und einem zweiten Stromverlauf.

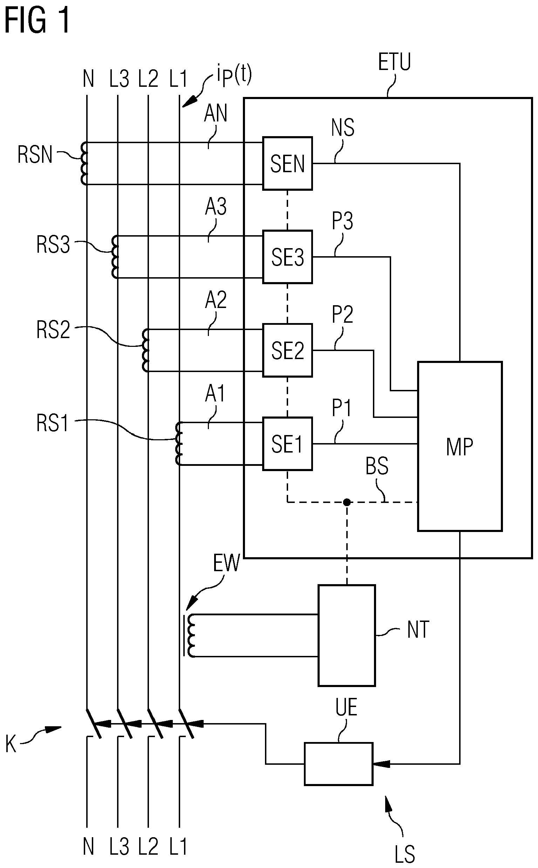

Figur 1 zeigt ein schematisches Blockschaltbild eines Niederspannungs-Leistungsschalters LS. Figur 1 zeigt elektrische Leiter L1, L2, L3, N eines Niederspannungsstromkreises, beispielsweise eines Dreiphasen-Wechselstromkreises, wobei der erste Leiter L1 die erste Phase mit dem ersten Phasenstrom ip(t) , der zweite Leiter L2 die zweite Phase mit dem zweiten Phasenstrom, der dritte Leiter L3 die dritte Phase mit dem dritten Phasenstrom und der vierte Leiter den Nullleiter N mit dem Nulleiterstrom des Dreiphasen-Wechselstromkreises bildet.

Im Beispiel gemäß Figur 1 ist der erste Leiter L1 mit einem Energiewandler EW verbunden (beispielsweise als Teil eines Wandlersatzes), derart, dass mindestens ein Teil des Stromes, d.h. ein Leiterteilstrom, bzw. der gesamte Strom des ersten Leiters L1 durch die Primärseite des Energiewandlers EW fließt. Üblicherweise bildet ein Leiter, im Beispiel der erste Leiter L1, die Primärseite des Energiewandlers EW. Der Energiewandler EW ist üblicherweise ein Transformator mit Kern, z.B. ein Eisenwandler. In einer Ausgestaltung kann in jeder Phase bzw. in jedem Leiter des elektrischen Stromkreises ein Energiewandler EW vorgesehen sein. Die Sekundärseite des Energiewandlers EW bzw. jedes vorgesehenen Energiewandler ist mit einem Netzteil NT (oder mehreren Netzteilen) verbunden, das eine Energieversorgung, z.B. eine Eigenversorgung, beispielsweise in Form einer

Versorgungsspannung, für die Einheiten des Niederspannungsleistungsschalters, insbesondere einer elektronischen Auslöseeinheit ETU, zur Verfügung stellt, dargestellt durch eine gestrichelt gezeichnete Verbindung von Betriebsspannungsleitern BS. Das Netzteil NT kann zudem noch mit mindestens einem oder allen Stromeinheiten SE1, SE2, SE3, SEN verbunden sein, zur Energieversorgung der Stromeinheiten - falls erforderlich.

Jede Stromeinheit SE1, SE2, SE3, SEN ist mit einer Rogowskispule RS1, RS2, RS3, RSN, zur Ermittlung der Höhe des elektrischen Stromes des ihm zugeordneten Leiters des elektrischen Stromkreises verbunden. Im Beispiel ist die erste Stromeinheit SE1 dem ersten Leiter L1, d.h. der ersten Phase; die zweite Stromeinheit SE2 dem zweiten Leiter L2, d.h. der zweiten Phase; die dritte Stromeinheit SE3 dem dritten Leiter L3, d.h. der dritten Phase; die vierte Stromeinheit SEN dem (vierten Leiter) Nullleiter N zugeordnet.

Die Rogowskispulen RS1, RS2, RS3, RSN liefern an ihrem Ausgang eine der Höhe des Leiterstromes proportionale analoge Spannung A1, A2, A3, AN. Diese wird den ersten bis vierten Stromeinheiten SE1, SE2, SE3, SEN zugeführt. Im Beispiel sind die ersten bis vierten Stromeinheiten SE1, SE2, SE3, SEN ein Teil der elektronischen Auslöseeinheit ETU. Sie können aber auch als separate Einheit(en) vorgesehen sein.

Die Stromeinheiten SE1, SE2, SE3, SEN dienen der Aufbereitung der Spannung der jeweiligen Rogowskispulen. Die Stromeinheiten SE1, SE2, SE3, SEN liefern beispielsweise ein digitales Signal P1, P2, P3, NS an einen Mikroprozessor MP, der z.B. in der elektronischen Auslöseeinheit ETU vorgesehen ist.

Die übermittelten digitale Signale P1, P2, P3, NS werden in der elektronischen Auslöseeinheit ETU mit Stromgrenzwerten oder/und Strom-Zeitspannen-Grenzwerten, die Auslösegründe bilden, verglichen. Bei Überschreitung dieser, wird eine Unterbrechung des elektrischen Stromkreises veranlasst. Hiermit wird ein Überstrom- oder/und Kurzschlussschutz realisiert. Dies kann beispielsweise dadurch erfolgen, dass eine Unterbrechungseinheit UE vorgesehen ist, die einerseits mit der elektronischen Auslöseeinheit ETU verbunden ist und andererseits Kontakte K zur Unterbrechung der Leiter L1, L2, L3, N bzw. weiterer Leiter aufweist. Die Unterbrechungseinheit UE erhält in diesem Fall ein Unterbrechungssignal zur Öffnung der Kontakte K.

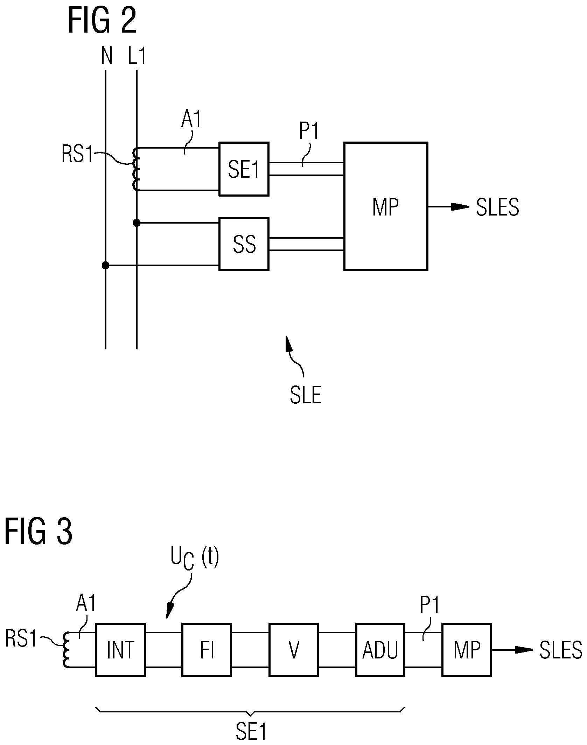

Figur 2 zeigt eine Anordnung zur Störlichtbogenerkennung mit einer Störlichtbogenerkennungseinheit SLE, wobei gleiche Einheiten gemäß Figur 1 vorgesehen sind. Diese weist mindestens eine Rogowskispule RS1 zur Ermittlung der Höhe des elektrischen Stromes eines Leiters L1 des Niederspannungswechselstromkreises auf, die eine analoge Spannung A1 abgibt, die ein Äquivalent der Höhe des elektrischen Stromes des Leiters L1 ist. Die Rogowskispule RS1 ist mit einer Stromeinheit SE1 verbunden.

Weiterhin weist sie mindestens einen Spannungssensor SS zur Ermittlung der Höhe der Spannung des Leiters L1 bzw. der Leiter des Niederspannungswechselstromkreises auf.

Ferner weist sie einen Mikroprozessor MP auf, die mit der Stromeinheit SE1 und dem Spannungssensor SS verbunden ist, wobei die ermittelte Höhe des Stromes und der Spannung des Niederspannungswechselstromkreises für eine Störlichtbogenerkennung durch den Mikroprozessor verwendet werden. Bei Überschreitung mindestens eines oder mehrerer Grenzwerte / Störlichtbogengrenzwerten wird ein Störlichtbogenerkennungssignal SLES abgegeben. Die Störlichtbogenerkennung kann nach bekannten Verfahren erfolgen, beispielsweise eine Signalverlaufsanalyse der Spannung oder/und des Stromes, eine differenzierende oder integrierende Lösung, etc.

Im Beispiel gemäß Figur 2 ist nur ein Stromkreis mit zwei Leitern gezeigt. In analoger Weise kann ein

Dreiphasenwechselstromkreis, mit oder ohne Nullleiter, vorgesehen sein.

Figur 3 zeigt eine Ausgestaltung einer Stromeinheit SE1 gemäß Figur 2 oder Figur 1. Diese weist einen analogen Integrator INT auf, der mit der Rogowskispule RS1 verbunden ist. Diesem wird die analoge Spannung A1 der Rogowskispule zugeführt. Mit analogen Integrator ist ein Integrator gemeint, der mit diskreten Bauelementen, wie Kondensatoren, Induktivitäten, Widerständen, etc. eine Integration durchführt, gemäß der analogen Schaltungstechnik. D.h. ein analoges Signal wird integriert.

Eine Integration mit digitalisierten Signalen und digitaler Schaltungstechnik, beispielsweise mit einem Mikroprozessor, ist nicht gemeint.

Der analoge Integrator INT liefert eine integrierte analoger Spannung uc(t). Diese wird in einer Variante direkte analog-digital umgesetzt, z.B. durch einen Analog-Digital-Umsetzer ADU, der ein digitales Signal P1 an den Mikroprozessor MP abgibt.

In verschiedenen erfindungsgemäßen Ausgestaltungen kann zwischen analogem Integrator INT und Analog-Digital-Umsetzer ADU ein Filter FI oder/und Verstärker V in beliebiger Reihenfolge vorgesehen sein, beispielsweise gemäß Figur 3. Alternativ kann auch vor dem Integrator INT ein Filter vorgesehen sein.

Der Mikroprozessor MP ist derart ausgestaltet, dass die durch die Rogowskispule RS1 und von der Rogowskispule nachgeschalteten Komponenten, insbesondere dem Integrator INT, gegebenenfalls dem Filter FI oder/und Verstärker V, erzeugte Phasenverschiebung kompensiert wird, so dass phasenrichtige Stromwerte ip(t) für die Störlichtbogenerkennung ermittelt und verwendet werden.

Die Stromeinheit SE1 bzw. die Anordnung/Ausgestaltung gemäß Figur 3 kann Teil des Niederspannungsleistungsschalters gemäß Figur 1 sein.

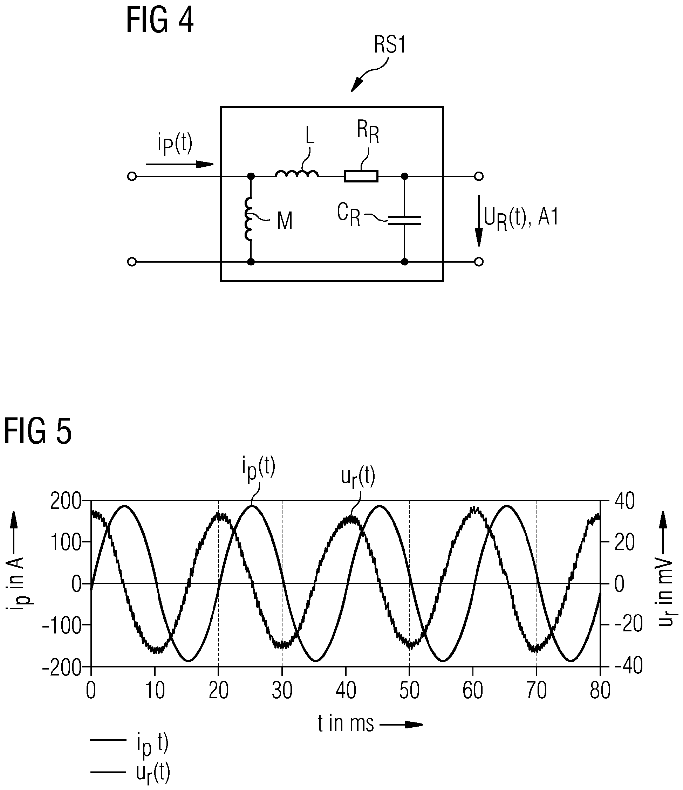

Figur 4 zeigt ein Ersatzschaltbild einer Rogowskispule RS1. Hierbei bewirkt ein Strom ip(t) des zugeordneten Leiters eine analoge Spannung ur(t) der Rogowskispule, diese entsprich der analogen Spannung A1. Zwischen den beiden Anschlüssen der Rogowskispule ist ersatzschaltbildseitig eine Gegeninduktivität M eingetragen, diese entspricht der magnetischen Kopplung. Auf Basis dieser Gegeninduktivität M wird eine zur Stromänderung im Leiter proportionale Spannung am Ausgang der Rogowksispule ur(t) bzw. A1 abgegeben.

$$u_{\mathrm{M}} = M_{\mathrm{R}} \frac{\mathrm{d}i_{\mathrm{M}}}{\mathrm{d}t}$$

Im Ersatzschaltbild gemäß Figur 4 führt die in Reihe liegende Streufeldinduktivität L zu einer Phasenverschiebung der Ausgangsspannung. Der in Reihe liegende Wicklungswiderstand RR führt zu einer Änderung der Amplitude. Ferner liegt eine Wicklungskapazität CR vor, die für eine praktische Betrachtung aufgrund der geringen Größe vernachlässigt werden kann.

Bedingt durch die in Reihe liegende Reaktanz und Resistanz entsprechend dem vereinfachten Ersatzschaltbild der Rogowskispule ergibt sich eine Phasenabweichung zwischen dem Primärstrom im Leiter und der Ausgangsspannung ur(t) bzw. A1 an der Rogowskispule.

Figur 5 zeigt dazu exemplarisch einen Verlauf. Figur 5 zeigt ein erstes Diagramm mit einem Spannungsverlauf ur bzw. ur(t) in mV der Ausgangsspannung der Rogowskispule und einen Stromverlauf ip bzw. ip(t) in A des Stromes des Leiters über der Zeit t in ms, die auf der horizontalen Achse angegeben ist.

Deutlich zu erkennen ist die Phasenverschiebung zwischen Strom und Spannung.

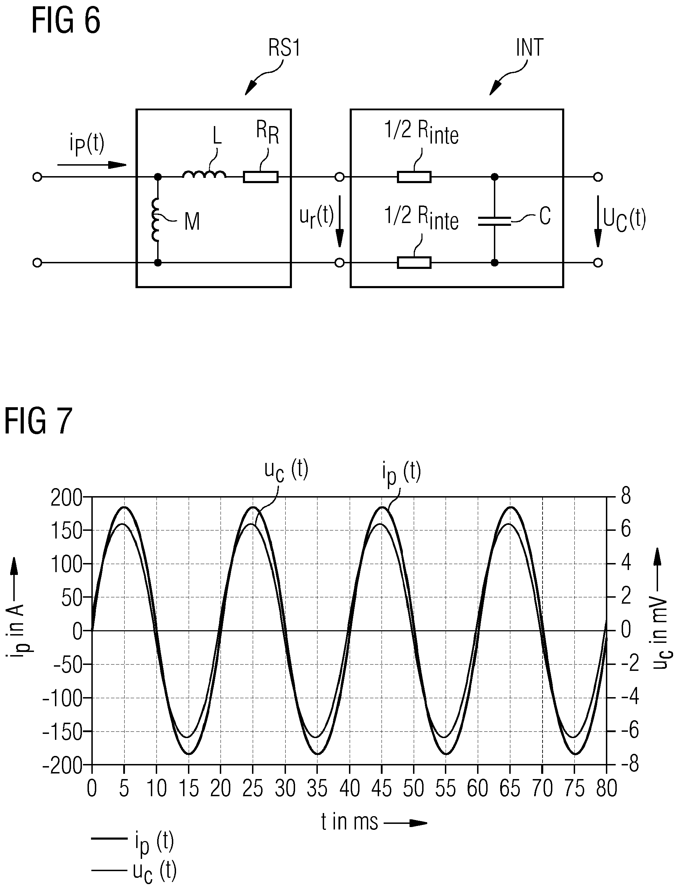

Figur 6 zeigt eine Anordnung gemäß Figur 4, mit dem Unterschied, dass am Ausgang der Rogowskispule RS1 ein Integrator INT angeschlossen ist, im Beispiel bestehend aus einen RC-Glied, wobei zwischen den beiden Leitern eine resultierende Kapazität C, z.B. in Form einer oder mehrerer Kondensatoren, und in Serie mindestens eines Leiters oder beider Leiter ein Integrator-Widerstand (Rinte) geschaltet ist.

Am Integrator INT wird hierbei die integrierte analoge Ausgangsspannung uc(t) abgegeben.

Figur 7 zeigt ein zweites Diagramm mit einem Spannungs- und Stromverlauf gemäß Figur 5, mit dem Unterschied, dass an Stelle der Spannung ur(t) bzw. A1 der Rogowskispule RS1 die integrierte analoge Spannung uc bzw. uc(t) in mV über der Zeit t in ms aufgetragen ist.

Durch die analoge Integration wird die Phasenverschiebung teilweise kompensiert, wie in Figur 7 zu erkennen ist, aber nicht vollständig.

Für die Erkennung von Störlichtbögen häufig nicht vollständig genug.

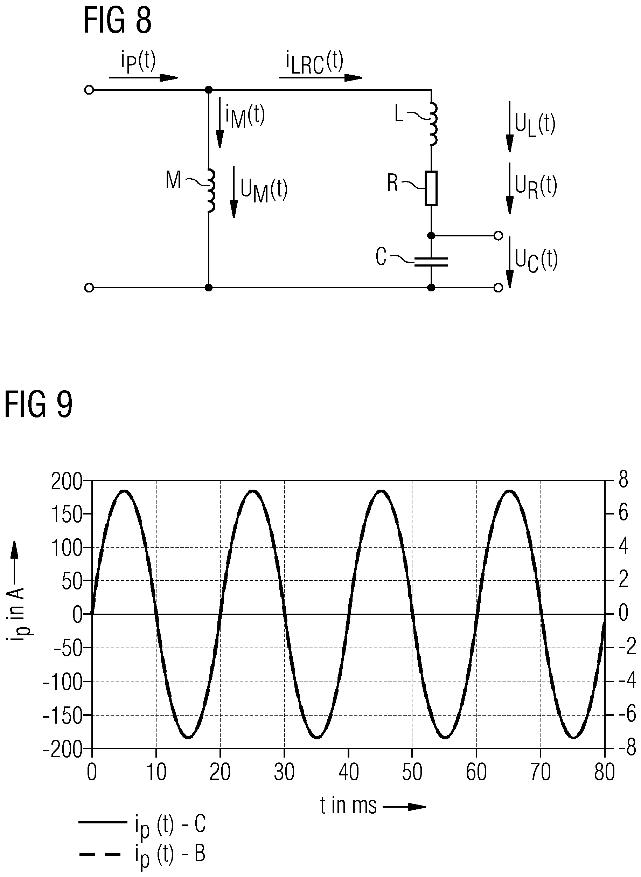

Figur 8 zeigt ein Ersatzschaltbild gemäß Figur 6 mit zusammengefassten Komponenten. Hierbei sind der Wicklungswiderstand RR der Rogowskispule und der Integrator-Widerstand Rinte zu einem resultierenden Widerstand R zusammengefasst, wobei der resultierende Widerstand R die Summe aus Wicklungswiderstand Rinte ist, R = RR + Rinte.

Figur 9 zeigt ein drittes Diagramm mit einem ersten und einem zweiten Stromverlauf gemäß Figur 5, mit dem Unterschied, dass an Stelle der integrierten analogen Spannung uc bzw. uc(t) der berechnete Strom ip bzw. ip(t) - B im Vergleich zum gemessenen Strom ip bzw. ip(t) - G über der Zeit t in ms aufgetragen ist.

Wie man sieht, wird durch die erfindungsgemäße Berechnung unter Verwendung eines Analog-Digital-Umsetzers ADU und eines Mikroprozessors MP, gegebenenfalls unter Verwendung und rechnerischer Einbeziehung eines Filters FI oder/und Verstärkers V, die Phasenverschiebung zwischen gemessenem und berechnetem Strom quasi vollständig kompensiert. Somit liegen phasenrichtige Stromwerte vor, die insbesondere für die Störlichtbogenerkennung als auch für die Erkennung von anderen Fehlersituationen zum Schutz des Niederspannungswechselstromkreises verwendet werden können.

In Bezug auf eine parallele Spannungsmessung, die keine Phasenverzögerung aufweist, liegen somit phasengenaue bzw. phasenrichtige Stromwerte vor, wobei diese phasenrichtigen Spannungs- und Stromwerte vorteilhaft für die Störlichtbogenerkennung oder die Erkennung von anderen Fehlersituationen zum Schutz des Niederspannungswechselstromkreises verwendet werden können.

Insbesondere für den Schutz von stromstarken Schalt- und Verteil-Anlagen können damit zukünftig auch in der Niederspannung numerische Algorithmen zum Einsatz kommen. Der Einsatz von z.B. Distanzschutzalgorithmen macht es dabei erforderlich, dass keine Phasenverschiebung zwischen den abgetasteten Strom- und Spannungsmesswerten vorliegt. Somit eignet sich für die Strommessung die Anwendung von Messwiderständen (Shunts). Diese bilden nach dem ohmschen Gesetz an den Ausgängen eine stromproportionale Spannung, die mit einem Spannungsmessgerät erfasst wird. Durch eine Rückrechnung lässt sich der Strom bestimmen. Die Verwendung magnetischer Wandler, z.B. von Rogowskispulen, für die Strommessung führt zu einer Phasenverschiebung des gemessenen Stroms, zeigt jedoch wesentliche Vorteile hinsichtlich der Potentialtrennung sowie der geringen Baugröße gegenüber Shunts.

Für die Berechnung des Stroms ist es notwendig das Ausgangssignal zu integrieren, da die gemessene Spannung lediglich zu der Stromänderung proportional ist. Hierzu können zwei Verfahren zum Einsatz kommen, zum einen eine numerische Integration, zum anderen eine analoge Integration. Numerische Integrationen zeigen Probleme bei großen Stromänderungen: die Auflösung eines nachgeschalteten Analog-Digital-Umsetzer bzw. A/D-Wandlers ist begrenzt. Eine große Stromänderung (z.B. bei einem Kurzschlusseintritt) führt zu sehr großen Spannungswerten, die ein Analog-Digital-Umsetzer eventuell nicht auflösen kann. Dieser Effekt wird als Clipping bezeichnet und führt zu fehlerhaften Ergebnissen.

Erfindungsgemäß wird daher eine analoge Integrator-Schaltung eingesetzt, die beispielsweise aus einem R-C Glied bestehen kann. In Verbindung mit der Rogowskispule ergibt sich ein Ersatzschaltbild entsprechend Figur 6, wobei die Wicklungskapazität der Rogowskispule vernachlässigt wurde. Die Phasenverschiebung wird durch den Integrator nur teilweise kompensiert. Die Phasendifferenz ist in Figur 7 dargestellt. Aufgrund der Phasendifferenz kommt es bei der Anwendung von Distanzschutzalgorithmen zu einem Fehler im Berechnungsergebnis. Somit wurde von einem bisherigen Einsatz von Rogowskispulen abgesehen.

Erfindungsgemäß wird nun der Strom im Leiter bzw. Primärstrom durch die Rückrechnung des Übertragungsverhaltens der Rogowskispule sowie des Integrators phasen- (und falls erforderlich amplitudenrichtig) bestimmt. Bei vorliegen weiterer phasenbeeinflussender (oder/und amplitudenbeinflussender) Komponenten werden diese bzw. können diese erfindungsgemäß ebenfalls rückgerechnet werden. Dazu wird entsprechend dem Ersatzschaltbild nach Figur 6 oder 8 eine Maschengleichung aufgestellt und gelöst. Auf dieser Basis lässt sich aus der Spannung der Rogowskispule bzw. der Spannung des Integrators der phasen- und amplitudenrichtige Primärstrom der Rogowskispule bestimmen.

Durch die phasen- und amplitudenrichtige Bestimmung des Primärstroms ist es mit der Erfindung möglich, dass Übertragungsverhalten von Rogowskispulen numerisch zu kompensieren. Somit können Rogowskispulen zukünftig in Schutzgeräten, wie Niederspannungsleistungsschaltern oder Störlichtbogenerkennungseinheiten, für die Erkennung anspruchsvoller Fehlersituationen Anwendung finden.

Entsprechend dem vereinfachten Ersatzschaltbild der Rogowskispule mit Integrator gemäß Figur 6 lassen sich die elektrischen Elemente zusammenfassen. Somit ergibt sich ein Ersatzschaltbild gemäß Figur 8.

Durch Lösen der Maschengleichung

$$u_M(t) = u_L(t) + u_R(t) + u_C(t) \qquad (1)$$

lässt sich die Spannung um(t) über der Gegeninduktivität M bestimmen und somit nach einer numerischen Integration, beispielsweise im Mikroprozessor MP, der Primärstrom iP berechnen. Die Spannung $u_C(t)$ ist der Messwert über der Kapazität C des Integrators INT. Für die Berechnung der einzelnen Spannungen wird im ersten Schritt der sekundärseitige Strom iLRC(t) berechnet:

$$i_{LRC}(t) = C\frac{du_C(t)}{dt} \qquad (2)$$

Damit lässt sich die Spannung über der zusammengefassten Resistanz von der Rogowskispule und Integrator entsprechend der folgenden Formel berechnen:

$$u_R(t) = RC\frac{du_C(t)}{dt} \qquad (3)$$

Die Spannung über einer Induktivität berechnet sich allgemein nach

$$u(t) = L\frac{di(t)}{dt} \qquad (4)$$

Entsprechend dem Ersatzschaltbild gemäß Figur 8 wird für die Berechnung der Spannung $u_L$ über der Induktivität der Strom $i_{LRC}$ verwendet.

$$u_L(t) = L\frac{di_{LRC}(t)}{dt} \qquad (5)$$

Durch Einsetzen der Gleichung 2 in Gleichung 5 lässt sich $u_L$ direkt aus der gemessenen Spannung $u_C$ berechnen:

$$u_L(t) = LC\frac{d^2u_C(t)}{d^2t} \qquad (6)$$

Mit Einsetzen der Gleichung 3 und 5 in die Gleichung 1, wird die Spannung $u_M(t)$ über der Gegeninduktivität der Rogowskispule berechnet:

$$u_M(t) = LC\frac{d^2u_C(t)}{d^2t} + RC\frac{du_C(t)}{dt} + u_C(t) \qquad (7)$$

Unter Berücksichtigung der Gegeninduktivität M und des Knotenpunktsatzes ermittelt sich durch die Integration der Stromänderung der Primärstrom wie folgt:

$$i_P(t) = \int \frac{LC\frac{d^2u_C(t)}{d^2t} + RC\frac{du_C(t)}{dt} + u_C(t)}{M}\, dt + C\frac{du_C(t)}{dt} \qquad (7)$$

Wird eine dementsprechende Berechnung angewandt, zeigt sich ein (quasi) übereinstimmender berechneter phasenrichtiger Stromwert ip(t) -B im Vergleich zu einem gemessenen Stromwert ip(t) - G, gemäß Figur 9.

Für eine hinreichend genaue Berechnung kann in der Praxis auf die Berücksichtigung des sekundärseitigen Stroms der Rogowskispule verzichtet werden.

Wird der Integrator INT an der Rogowskispule um eine bzw. mehrere Filter bzw. Filterschaltungen FI erweitertet, so sind diese Elemente vorteilhaft entsprechend einem Ersatzschaltbild im Übertragungsverhalten zu berücksichtigen. In Anlehnung an den dargestellten Lösungsweg, mit einer aufgestellten Maschengleichung, kann das Übertragungsverhalten bestimmt und somit der Primärstrom berechnet werden.

Die Erfindung hat den Vorteil, dass die klassischen Stromwandler (große Bauform) durch kompakte, leichte Rogowskispulen ersetzt werden können.

Obwohl die Erfindung im Detail durch das Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Die Erfindung ist nur durch die Ansprüche definiert.

**Patentansprüche**

1. Störlichtbogenerkennungseinheit (SLE) für einen Niederspannungswechselstromkreis,

   - mit mindestens einer Rogowskispule (RS1) zur Ermittlung der Höhe des elektrischen Stromes eines Leiters (L1) des Niederspannungswechselstromkreises, die eine analoge Spannung (A1) abgibt, die ein Äquivalent der Höhe des elektrischen Stromes des Leiters ist,
   - mit mindestens einem Spannungssensor (SS) zur Ermittlung der Höhe der Spannung des Leiters (L1) der Niederspannungswechselstromkreises,
   - mit einem Mikroprozessor (MP), der mit der ermittelten Höhe des Stromes und der Spannung des Niederspannungswechselstromkreises eine Störlichtbogenerkennung durchführt und bei Überschreitung mindestens eines Grenzwertes ein Störlichtbogenerkennungssignal (SLES) abgibt,

   **dadurch gekennzeichnet,**
   **dass** die Rogowskispule (RS1) mit einem analogen Integrator (INT) verbunden ist, dem ein Analog-Digital-Umsetzer (ADU) folgt, der die integrierte analoge Spannung (uc(t)) in ein digitales Signal (P1) umsetzt, das durch den Mikroprozessor (MP) derart weiterverarbeitet wird, dass die durch die Rogowskispule (RS1) und von der Rogowskispule nachgeschalteten Komponenten erzeugte Phasenverschiebung kompensiert wird, so dass phasenrichtige Stromwerte (ip(t)) für die Störlichtbogenerkennung ermittelt und verwendet werden.

2. Anordnung nach einem der vorhergehenden Patentansprüche,
   **dadurch gekennzeichnet,**
   **dass** zwischen Rogowskispule (RS1) und Analog-Digital-Umsetzer (ADU) ein Verstärker (V) vorgesehen ist.

3. Anordnung nach einem der vorhergehenden Patentansprüche,
   **dadurch gekennzeichnet,**
   **dass** der Rogowskispule (RS1) oder dem Integrator (INT) ein Filter (FI) nachgeschaltet oder dem Analog-Digital-Umsetzer (ADU) ein Filter (FI) vorgeschaltet ist.

4. Anordnung nach einem der vorhergehenden Patentansprüche,
   **dadurch gekennzeichnet,**

   **dass** die Rogowskispule (RS1) durch eine Gegeninduktivität (M), eine Streufeldinduktivität (L) und einen Wicklungswiderstand (RR) gekennzeichnet ist;
   **dass** der analoge Integrator (INT) mindestens eine Widerstands-Kondensator Anordnung aufweist, mit einer resultierenden Kapazität (C) und einem Integrator-Widerstand (Rinte).

5. Anordnung nach Patentanspruch 4,
   **dadurch gekennzeichnet,**
   **dass** aus dem digitalen Signal (P1, P2, P3, PN) mittels der Gegeninduktivität (M), der Streufeldinduktivität (L), der resultierenden Kapazität (C) und der Summe aus Wicklungswiderstand (RR) und Integrator-Widerstand (Rinte), die einen resultierenden Widerstand (R) bilden, phasenrichtige Stromwerte (ip(t)) errechnet werden.

6. Anordnung nach Patentanspruch 5,

**dadurch gekennzeichnet,**
**dass** die phasenrichtigen Stromwerte (ip(t)) der Höhe des Stromes des Leiters durch zeitliche (dt) Integration gemäß folgender Formel errechnet werden:

$$i_{\mathrm{P}}(t) = \int \frac{LC\frac{\mathrm{d}^2 u_{\mathrm{C}}(t)}{\mathrm{d}^2 t} + RC\frac{\mathrm{d}u_{\mathrm{C}}(t)}{\mathrm{d}t} + u_{\mathrm{C}}(t)}{M}\, \mathrm{d}t + C\frac{\mathrm{d}u_{\mathrm{C}}(t)}{\mathrm{d}t}$$

7. Verfahren zur Störlichtbogenerkennung für einen Niederspannungswechselstromkreis,

- bei dem Spannungswerte mindestens eines Leiter des Niederspannungswechselstromkreis ermittelt werden,
- bei dem mit einer Rogowskispule Stromwerte des mindestens einem Leiters des Niederspannungswechselstromkreis ermittelt werden, wobei die Rogowskispule eine analoge Spannung (A1) abgibt, die ein Äquivalent der Höhe des elektrischen Stromes des Leiters ist,
- die Spannungswerte und Stromwerte einem Mikroprozessor (MP) zugeführt werden, der derart ausgestaltet ist, das eine Störlichtbogenerkennung durchgeführt wird und bei Überschreitung mindestens eines Grenzwertes ein Störlichtbogenerkennungssignal (SLES) abgegeben wird,

**dadurch gekennzeichnet,**
**dass** die analoge Spannung integriert wird und derart weiterverarbeitet wird, dass die durch die Rogowskispule und den Integrator erzeugte Phasenverschiebung kompensiert wird, derart dass phasenrichtige Stromwerte (ip(t)) für die Störlichtbogenerkennung ermittelt und verwendet werden.

8. Verfahren nach Patentanspruch 7,
**dadurch gekennzeichnet,**
**dass** die analoge Spannung oder integrierte analoge Spannung gefiltert oder verstärkt wird.

9. Verfahren nach Patentanspruch 7 oder 8,
**dadurch gekennzeichnet,**
**dass** die Kompensation der Phasenverschiebung im Mikroprozessor durchgeführt wird, der durch numerische Rückberechnung mittels der Gegeninduktivität (M), der Streufeldinduktivität (L), der resultierenden Kapazität (C) und der Summe aus Wicklungswiderstand (RR) und resultierenden Widerstand (Rinte) phasenrichtige Stromwerte (ip(t)) errechnet.

10. Verfahren nach Patentanspruch 9,
**dadurch gekennzeichnet,**
**dass** bei der numerischen Rückberechnung die physikalischen Größen weiterer Komponenten, insbesondere eines Filters oder/und Verstärkers, berücksichtigt werden.

**Claims**

1. Fault arc detection unit (SLE) for a low-voltage AC circuit,

- comprising at least one Rogowski coil (RS1) for ascertaining the electric current level of a conductor (L1) of the low-voltage AC circuit, which Rogowski coil outputs an analogue voltage (A1) that is equivalent to the electric current level of the conductor,
- comprising at least one voltage sensor (SS) for ascertaining the level of the voltage of the conductor (L1) of the low-voltage AC circuit,
- comprising a microprocessor (MP) that carries out a fault arc detection with the ascertained current level and voltage level of the low-voltage AC circuit and, when at least one limit value is exceeded, outputs a fault arc detection signal (SLES),

**characterized**
**in that** the Rogowski coil (RS1) is connected to an analogue integrator (INT) that is followed by an analogue-digital converter (ADU) that converts the integrated analogue voltage (uc(t)) into a digital signal (P1) that is processed further by the microprocessor (MP) in such a way that the phase shift generated by the Rogowski coil (RS1) and by components that follow the Rogowski coil is compensated for, so that correct-phase current values (ip(t)) are ascertained and used for the fault arc detection.

2. Arrangement according to one of the preceding patent claims,
   **characterized**
   **in that** an amplifier (V) is provided between the Rogowski coil (RS1) and the analogue-digital converter (ADU).

3. Arrangement according to either of the preceding patent claims,
   **characterized**
   **in that** a filter (FI) follows the Rogowski coil (RS1) or the integrator (INT), or a filter (FI) precedes the analogue-digital converter (ADU).

4. Arrangement according to one of the preceding patent claims,
   **characterized**

   **in that** the Rogowski coil (RS1) is **characterized by** a mutual inductance (M), a stray field inductance (L) and a winding resistance (RR);
   in that the analogue integrator (INT) comprises at least one resistor/capacitor arrangement with a resultant capacitance (C) and an integrator resistance (Rinte).

5. Arrangement according to Patent Claim 4,
   **characterized**
   **in that** correct-phase current values (ip(t)) are calculated from the digital signal (P1, P2, P3, PN) by means of the mutual inductance (M), the stray field inductance (L), the resultant capacitance (C) and the sum of the winding resistance (RR) and the integrator resistance (Rinte) that form a resultant resistance (R).

6. Arrangement according to Patent Claim 5,
   **characterized**
   **in that** the correct-phase current values (ip(t)) of the current level of the conductor are calculated by integrating over time (dt) in accordance with the following formula:

$$i_{\mathrm{P}}(t) = \int \frac{LC\,\dfrac{\mathrm{d}^2 u_{\mathrm{C}}(t)}{\mathrm{d}^2 t} + RC\,\dfrac{\mathrm{d}u_{\mathrm{C}}(t)}{\mathrm{d}t} + u_{\mathrm{C}}(t)}{M}\,\mathrm{d}t + C\,\frac{\mathrm{d}u_{\mathrm{C}}(t)}{\mathrm{d}t}$$

7. Fault arc detection method for a low-voltage AC circuit,

   - in which voltage values of at least one conductor of the low-voltage AC circuit are ascertained,
   - in which current values of the at least one conductor of the low-voltage AC circuit are ascertained with a Rogowski coil, wherein the Rogowski coil outputs an analogue voltage (A1) that is equivalent to the electric current level of the conductor,
   - the voltage values and current values are supplied to a microprocessor (MP) that is configured in such a way that an arc fault detection is carried out and, when at least one limit value is exceeded, an arc fault detection signal (SLES) is output,

   **characterized**
   **in that** the analogue voltage is integrated and is processed further in such a way that the phase shift generated by the Rogowski coil and the integrator is compensated for in such a way that correct-phase current values (ip(t)) are ascertained and used for the fault arc detection.

8. Method according to Patent Claim 7,
   **characterized**
   **in that** the analogue voltage or integrated analogue voltage is filtered or amplified.

9. Method according to Patent Claim 7 or 8,
   **characterized**
   **in that** the phase shift is compensated for in the microprocessor that calculates correct-phase current values (ip(t)) through numerical back-calculation by means of the mutual inductance (M), the stray field inductance (L), the resultant capacitance (C) and the sum of the winding resistance (RR) and the resultant resistance (Rinte).

10. Method according to Patent Claim 9,
    **characterized**
    **in that** the physical magnitudes of further components, in particular of a filter and/or amplifier, are taken into consideration in the numerical back-calculation.

**Revendications**

1. Unité de détection d'arc parasite (SLE) pour un circuit de courant alternatif basse tension,

   - qui comprend au moins une bobine de Rogowski (RS1) destinée à déterminer le niveau du courant électrique d'un conducteur (L1) du circuit de courant alternatif basse tension, qui délivre une tension analogique (AI) qui représente un équivalent du niveau du courant électrique du conducteur ;
   - qui comprend au moins un capteur de tension (SS) destiné à déterminer le niveau de la tension du conducteur (L1) du circuit de courant alternatif basse tension ;
   - qui comprend un microprocesseur (MP) qui, avec le niveau du courant et celui de la tension du circuit de courant alternatif basse tension qui ont été déterminés, met en œuvre une détection d'arc parasite et émet un signal de détection d'arc parasite (SLES) dans le cas d'un dépassement vers le haut d'au moins une valeur limite ;

   **caractérisé**
   **en ce que** la bobine de Rogowski (RS1) est reliée à un intégrateur analogique (INT) auquel fait suite un convertisseur analogique-numérique (ADU) qui convertit la tension analogique intégrée (uc(t)) en un signal numérique (P1) qui fait l'objet d'un traitement ultérieur par le microprocesseur (MP) d'une manière telle que le décalage de phase produit par la bobine de Rogowski (RS1) et par les composants montés en aval de la bobine de Rogowski est compensé, tant et si bien que l'on détermine et que l'on utilise des valeurs de courant en phase (ip(t)) pour la détection d'arc parasite.

2. Agencement selon l'une quelconque des revendications précédentes, **caractérisé**
   **en ce que** l'on prévoit un amplificateur (V) entre la bobine de Rogowski (RS1) et le convertisseur analogique-numérique (ADU).

3. Agencement selon l'une quelconque des revendications précédentes,
   **caractérisé**
   **en ce qu'**un filtre (FI) est monté en aval de la bobine de Rogowski (RS1) ou de l'intégrateur (INT) ou qu'un filtre (FI) est monté en amont du convertisseur analogique-numérique (ADU).

4. Agencement selon l'une quelconque des revendications précédentes, **caractérisé**

   **en ce que** la bobine de Rogowski (RS1) est **caractérisée par** une inductance mutuelle (M), une inductance de fuite (L) et une résistance d'enroulement (RR) ;
   en ce que l'intégrateur analogique (INT) présente au moins un agencement résistance-condensateur qui comprend une capacité résultante (C) et une résistance d'intégrateur (Rinte).

5. Agencement selon la revendication 4,
   **caractérisé**
   **en ce que**, à partir du signal numérique (P1, P2, P3, PN) au moyen de l'inductance mutuelle (M), de l'inductance de fuite (L), de la capacité résultante (C) et de la somme de la résistance d'enroulement (RR) et de la résistance d'intégrateur (Rinte), qui forment une résistance résultante (R), on calcule des valeurs de courant en phase (ip(t)).

6. Agencement selon la revendication 5,
   **caractérisé**
   **en ce que** l'on calcule les valeurs de courant en phase (ip(t)) du niveau du courant du conducteur par l'intermédiaire d'une intégration temporelle (dt) en conformité avec la formule suivante :

$$i_{\mathrm{P}}(t) = \int \frac{LC\frac{\mathrm{d}^2 u_{\mathrm{C}}(t)}{\mathrm{d}^2 t} + RC\frac{\mathrm{d}u_{\mathrm{C}}(t)}{\mathrm{d}t} + u_{\mathrm{C}}(t)}{M}\, \mathrm{d}t + C\frac{\mathrm{d}u_{\mathrm{C}}(t)}{\mathrm{d}t}$$

**7.** Procédé destiné à la détection d'un arc électrique parasite pour un circuit de courant alternatif basse tension :

- dans lequel on détermine des valeurs de tension d'au moins un conducteur du circuit de courant alternatif basse tension ;
- dans lequel on détermine, avec une bobine de Rogowski, des valeurs de courant dudit au moins un conducteur du circuit de courant alternatif basse tension ; dans lequel la bobine de Rogowski délivre une tension analogique (A1) qui représente un équivalent du niveau du courant électrique du conducteur ;
- on achemine les valeurs de tension et les valeurs de courant à un microprocesseur (MP) qui est conçu d'une manière telle qu'une détection d'arc parasite est mise en œuvre et qu'un signal de détection d'arc parasite (SLES) est émis dans le cas d'un dépassement vers le haut d'au moins une valeur limite ;

**caractérisé**
**en ce que** la tension analogique est intégrée et est soumise à un traitement ultérieur d'une manière telle que le décalage de phase produit par la bobine de Rogowski et par l'intégrateur est compensé, tant et si bien que l'on détermine et que l'on utilise des valeurs de courant en phase (ip(t)) pour la détection d'arc parasite.

**8.** Procédé selon la revendication 7,
**caractérisé**
**en ce que** l'on filtre ou l'on amplifie la tension analogique ou la tension analogique intégrée.

**9.** Procédé selon la revendication 7 ou 8,
**caractérisé**
**en ce que** la compensation du décalage de phase est mise en œuvre dans le microprocesseur qui, par l'intermédiaire d'un calcul numérique rétrospectif au moyen de l'inductance mutuelle (M), de l'inductance de fuite (L), de la capacité résultante (C) et de la somme de la résistance d'enroulement (RR) et de la résistance résultante (Rinte), calcule des valeurs de courant en phase (ip(t)).

**10.** Procédé selon la revendication 9,
**caractérisé**
**en ce que** que, lors du calcul numérique rétrospectif, on prend en compte les grandeurs physiques d'autres composants, en particulier d'un filtre et/ou d'un amplificateur.

# FIG 1

**FIG 2**

**FIG 3**

FIG 4

FIG 5

FIG 6

FIG 7

## FIG 8

$i_P(t)$

$i_{LRC}(t)$

$i_M(t)$

L

$U_L(t)$

M

$U_M(t)$

R

$U_R(t)$

C

$U_C(t)$

## FIG 9

— $i_p$ (t) – C

– – $i_p$ (t) – B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- FR 3059783 A1
- DE 102004011023 A1